# EUROPÄISCHE PATENTSCHRIFT

(11) **EP 3 259 827 B1**
(45) Veröffentlichungstag und Bekanntmachung des Hinweises auf die Patenterteilung: **04.11.2020**
(21) Anmeldenummer: 16701648.4
(22) Anmeldetag: 27.01.2016
(51) Int. Cl.: H02J 9/06, G01R 31/327, H02H 11/00, G01R 27/20, G01R 31/52, H02H 7/22

(54) **NETZERSATZANLAGE, ERDUNGSEINRICHTUNG FÜR EINE NETZERSATZANLAGE UND BETRIEBSVERFAHREN**
EMERGENCY POWER SYSTEM, GROUNDING DEVICE FOR AN EMERGENCY POWER SYSTEM AND OPERATING METHOD
INSTALLATION DE REMPLACEMENT DE RÉSEAU, SYSTÈME DE MISE À LA TERRE POUR UNE INSTALLATION DE REMPLACEMENT DE RÉSEAU ET PROCÉDÉ DE FONCTIONNEMENT

(30) Priorität: 20.02.2015 DE 102015102468
(43) Veröffentlichungstag der Anmeldung: 27.12.2017
(73) Patentinhaber: SMA Solar Technology AG, 34266 Niestetal (DE)
(72) Erfinder: RUEHLING, Christian, 34298 Helsa (DE); MUYLLAERT, Koenraad, 34131 Kassel (DE)
(86) Internationale Anmeldenummer: PCT/EP2016/051641
(87) Internationale Veröffentlichungsnummer: WO 2016/131620

(56) Entgegenhaltungen:
- DE-A1- 3 429 067
- DE-U1-202010 008 123

## Beschreibung

Die Erfindung betrifft eine Erdungseinrichtung für eine Netzersatzanlage zum Verbinden eines Neutralleiters einer Verbraucheranordnung mit einem lokalen Erdungsanschluss über mindestens einen als Schließkontakt ausgeführten Schaltkontakt einer Schalteinrichtung. Die Erfindung betrifft weiterhin eine Netzersatzanlage mit einer derartigen Erdungseinrichtung, sowie ein Verfahren zum Betreiben der Netzersatzanlage.

Netzersatzanlagen dienen der Bereitstellung von elektrischer Energie für eine Verbraucheranordnung für den Fall, dass ein übergeordnetes, ggf. öffentliches Energieversorgungsnetz diese Energie nicht bereitstellen kann, beispielsweise aufgrund eines Ausfalls und/oder einer Störung des übergeordneten Energieversorgungsnetzes. Eine Umschalteinrichtung übernimmt dabei das notwendige Trennen der Verbraucheranordnung vom Energieversorgungsnetz und das anschließende Verbinden mit einer lokalen Energieerzeugungseinrichtung, wie beispielsweise einem Generator, einer Photovoltaikanlage und/oder einem Wechselrichter, der mit einem Energiespeicher, z.B. einer Batterie, gekoppelt ist. Eine derartige Netzersatzanlage zum Umschalten von einem Normalbetrieb bei Versorgung über ein Energieversorgungsnetz auf einen Inselbetrieb bei Versorgung durch einen lokalen Energieerzeuger ist beispielsweise aus der Druckschrift EP 1 965 483 A1 bekannt.

Insbesondere bei einem als TT-Netz (Terre-Terre Netz) ausgebildeten Energieversorgungsnetz ist eine allpolige Trennung der Verbraucheranordnung vom Energieversorgungsnetz gefordert, wenn die Verbraucheranordnung im Inselbetrieb mit lokal bereitgestellter elektrischer Energie versorgt wird. Bei der allpoligen Trennung wird auch der Neutral- oder Nullleiter getrennt, der innerhalb des Energieversorgungsnetzes geerdet ist. Durch die mit dem Inselbetrieb verbundene Trennung wird die bis dahin bestehende Erdung des Neutralleiters der Verbraucheranordnung aufgehoben. Ohne eine weitere Aktion durchzuführen besteht somit im Inselbetrieb keine Erdung des Neutralleiters der Verbraucheranordnung. Dies kann zu Problemen mit eingesetzten Fehlerstromschutzschaltern führen, da der Fehlerstrom nicht korrekt über Erde abgeführt werden kann. So wird eine Fehlerschleife nicht geschlossen und der entsprechende Fehlerstromschutzschalter löst nicht wie vorgesehen aus.

Aus der Druckschrift DE 10 2010 000 502 A1 ist zur Umgehung dieses Problems bekannt, den Nullleiter in der Verbraucheranordnung dauerhaft über einen Widerstand mit einem Erdungsanschluss zu verbinden, also mit Erdpotential zu beaufschlagen. In manchen Energieversorgungsnetzen gibt es seitens der Betreiber der Energieversorgungsnetze jedoch Richtlinien, mit denen diese Vorgehensweise nicht konform ist. Zudem können ggf. vorhandene und unmittelbar zum Netzanschluss gehörende Fehlerstromschutzschalter durch den über den Widerstand fließenden Strom im Netzbetrieb schon auslösen, ohne dass ein Fehler vorliegt. Eine derartige Fehlauslösung der Fehlerstromschutzschalter, führt zu einer unerwünschten Unterbrechung von Verbrauchern und ist daher zu vermeiden.

Weiterhin ist aus der Druckschrift DE 20 2010 008 123 U1 bekannt, den Neutralleiter der Verbraucheranordnung über einen im Inselbetrieb geschlossenen Schalter mit einem lokalen Erdungsanschluss zu verbinden. Auf diese Weise kann eine Erdung eines Neutralleiters in der Verbraucheranordnung bereitgestellt werden, ohne dass eine unter Umständen nicht richtlinienkonforme dauerhafte Erdung vorliegt. Auch die Druckschrift US 6,100,605 A offenbart eine Netzersatzanlage mit einer Erdungseinrichtung zur Verbindung eines Neutralleiters mit einem Erdungsleiter über mindestens einen Schließkontakt. Bei derartigen, geschalteten Erdungsverbindungen besteht jedoch die Gefahr, dass eine Verbindung durch Betätigen des Erdungsschalters zwar vorgesehen ist, diese aufgrund von Kontaktproblemen beim Schalter oder einem sonstigen Defekt nicht oder nur mit einem nicht ausreichend kleinen Übergangswiderstand realisiert ist und der Personenschutz dann nicht mehr gewährleistet ist.

Die Schrift DE 196 01 880 A offenbart eine Verbrauchernetzanordnung mit zumindest einem Außenleiter, einem Schutzleiter, gegebenenfalls einem Neutralleiter und einer Anordnung zur Überwachung des Schutzleiters auf seine Funktionstüchtigkeit. Dabei gibt eine Prüfstromeinrichtung Prüfstrom permanent auf den Schutzleiter. Der Prüfstrom wird von einem Prüfstromsensor detektiert und einer Auswerteeinrichtung zugeführt, die für einen Prüfstrom unterhalb eines vorbestimmten Schwellwertes einer Betätigungseinrichtung einer Schalteinrichtung ein öffnendes Schaltsignal zuführt.

Die Schrift DE 3429067 A1 offenbart eine Schaltung zur kontinuierlichen Überwachung eines Erdungswiderstandes elektrischer Geräte, deren berührbare elektrisch leitende Bauteile über einen Schutzleiter mit einem Erdpotential verbunden sind. Dabei wird eine der stromführenden Zuleitungen des Gerätes über eine Reihenschaltung aus zumindest einem Messwiderstand, einem Test-Impulsgenerator und einem Kondensator mit dem Schutzleiter verbunden.

Die DE 10 2012 219542 A1 offenbart eine Überwachungsvorrichtung für einen Schutzleiter aufweisend einen Bezugspotentialerzeuger, einen Prüfstromerzeuger zum Erzeugen eines Prüfstroms, eine Erfassungsvorrichtung zum Erzeugen einer von dem Prüfstrom abhängigen Größe und eine Auswertevorrichtung zum Auswerten der erzeugten Größe. Der Bezugspotentialerzeuger weist mindestens eine Kapazität und/oder mindestens eine Diode auf. Der Prüfstromerzeuger kann dazu vorbereitet sein, den Prüfstrom nach einer Prüfphase nicht oder nur intermittierend zu erzeugen.

Zudem sind Schalteinrichtungen bekannt, bei denen neben einem Hauptschalter noch ein mit dem Hauptschalter zwangsgeführter Hilfsschalter (z. B. ein Spiegelkontakt) vorgesehen ist, über den der Schaltzustand des Hauptschalters abgefragt werden kann. Über einen derartigen Hilfsschalter kann gesichert jedoch nur eine Aussage gemacht werden, dass der Hauptschalter geöffnet ist, nicht aber, ob der Hauptschalter mit einem geringen Übergangswiderstand geschlossen ist.

Aus der Druckschrift WO 2013/144316 A1 ist eine Erdungseinrichtung für eine Netzersatzanlage bekannt, bei der ein Neutralleiter der Verbraucheranordnung über eine Reihenschaltung von zwei Schaltern mit einem Neutralleiter einer lokalen Energieversorgungseinrichtung verbunden ist, wobei ein Mittelabgriff zwischen den beiden Schaltern mit dem lokalen Erdungsanschluss verbunden ist. Dadurch, dass der Strom von der lokalen Energieversorgungseinrichtung zur Verbraucheranordnung über die Reihenschaltung der beiden Schalter fließt, die gleichzeitig auch die Verbindung des Neutralleiters der Verbraucheranordnung mit dem lokalen Erdungsanschluss herstellt, ist ein Betriebszustand, in dem die Verbraucheranordnung über die Energieversorgungseinrichtung versorgt wird, ohne dass eine Erdung des Neutralleiters der Verbraucheranordnung vorliegt, ausgeschlossen. Die beschriebene Anordnung setzt voraus, dass die beiden Schalter Ruheschalter mit Öffnerkontakten sind, die jeweils in einem Schütz lokalisiert sind, welches hoch strömbelastbare Öffner- und Schließkontakte aufweist. Schütze mit gleichzeitig vorhandenen hoch strömbelastbaren Öffner- und Schließkontakten werden jedoch in der Installationstechnik selten eingesetzt und sind - wenn überhaupt verfügbar - entsprechend teurer als gängige Schütze, deren hoch strömbelastbare Hauptkontakte lediglich als Schließkontakte ausgebildet sind. Die gängigen Schütze mit hoch strombelastbaren Schließkontakten enthalten entweder keine gleichzeitig vorhandenen Öffnerkontakte, oder sie weisen ggf. nur als Hilfskontakte ausgebildete und daher nicht hoch strombelastbare Öffnerkontakte auf. Derartige Hilfskontakte werden beispielsweise zu Überwachungszwecken genutzt.

Es ist daher eine Aufgabe der vorliegenden Erfindung, eine Erdungseinrichtung und eine Netzersatzanlage anzugeben, die einen Neutralleiter einer Verbraucheranordnung bedarfsweise bei Trennung von einem Energieversorgungsnetz mit einem lokalen Erdungsleiter verbinden kann, wobei eine korrekte, niederimpedante, insbesondere niederohmige Erdung des Neutralleiters sicher überwacht werden kann und die mit gängigen Schalteinrichtungen aufgebaut ist. Insbesondere sollen als Schalteinrichtungen gängige Schütze einsetzbar sein, die als Hauptkontakte nur Schließkontakte aufweisen. Weiterhin ist es Aufgabe der vorliegenden Erfindung, ein Verfahren zum Betrieb der Netzersatzanlage aufzuzeigen.

Diese Aufgabe wird gelöst durch eine Erdungseinrichtung für eine Netzersatzanlage mit den Merkmalen des unabhängigen Anspruchs 1. Die Aufgabe wird zudem gelöst durch eine Netzersatzanlage mit einer derartigen Erdungseinrichtung und ein Verfahren zum Betrieb der Netzersatzanlage. Vorteilhafte Ausgestaltungen und Weiterbildungen der Erdungseinrichtung, der Netzersatzanlage und des Verfahrens sind Gegenstand der abhängigen Ansprüche.

Eine erfindungsgemäße Erdungseinrichtung der eingangs genannten Art zeichnet sich dadurch aus, dass ein gegenüber dem Neutralleiter mit Spannung beaufschlagter Leiter über eine Reihenschaltung aus einem stromreduzierenden Element und einem weiteren Schließkontakt (11.3) mit dem Erdungsleiter schaltbar verbunden ist. Dabei wird durch die Verbindung des Erdungsleiters mit dem mit Spannung beaufschlagten Leiter über das stromreduzierende Element ein Strompfad gebildet, der ausgehend von dem mit Spannung beaufschlagten Leiter über den Erdungsleiter zum Neutralleiter führt, wobei in dem Strompfad dann ein Strom fließt, wenn der Erdungsleiter über den mindestens einen Schließkontakt mit dem Neutralleiter verbunden ist. Dabei ist in einer Reihenschaltung zu dem mindestens einen Schließkontakt und/oder zu dem stromreduzierenden Element ein Stromsensor angeordnet.

Durch die Verbindung des Erdungsleiters mit dem mit Spannung beaufschlagten Leiter über das stromreduzierende Element wird ein Strompfad gebildet, in dem dann ein Strom fließt, wenn der Erdungsleiter über den mindestens einen Schließkontakt mit dem Neutralleiter verbunden, insbesondere korrekt mit dem Neutralleiter verbunden ist. Dabei wird der Strom getrieben über eine Spannungsdifferenz zwischen dem mit Spannung beaufschlagten Leiter und dem Neutralleiter und begrenzt über das stromreduzierende Element. Der Stromsensor ermöglicht es, diesen Strom zu detektieren und anhand des detektierten Stroms die Verbindung zwischen Neutralleiter und Erdungsleiter an sich, insbesondere aber auch die korrekte Verbindung zwischen Neutralleiter und Erdungsleiter nachzuweisen. Dabei wird die Verbindung an sich darüber nachgewiesen, ob überhaupt ein von 0 verschiedener Strom detektiert wird. Die korrekte Verbindung zwischen Erdungsleiter und Neutralleiter lässt sich über einen Vergleich des detektierten Stroms mit einem eine korrekte und insbesondere niederimpedante Verbindung charakterisierenden vordefinierten Schwellwert nachweisen. Ist beispielsweise ein signifikanter Übergangswiderstand an dem mindestens einen Schließkontakt vorhanden, so beeinflusst dieser den Strom in dem Strompfad zusätzlich zu dem stromreduzierenden Element in messbarer Weise.

Der Strompfad ist somit gleichbedeutend mit einem Messstromkreis zur Detektion der Verbindung insbesondere der korrekten Verbindung zwischen dem Neutralleiter und dem Erdungsleiter. Dabei erlaubt einerseits die Existenz eines von 0 verschiedenen Stroms in dem Strompfad eine Aussage darüber, ob überhaupt eine Verbindung zwischen dem Neutralleiter und dem Erdungsleiter vorliegt. Zusätzlich zu der an sich vorliegenden Verbindung lässt sich jedoch unter Berücksichtigung weiterer Eigenschaften des fließenden Stroms - z.B. Stromhöhe, Phasenlage des Stroms zu der treibenden Spannung des mit Spannung beaufschlagten Leiters - auch eine Aussage über die Qualität der Verbindung zwischen dem Neutralleiter und dem Erdungsleiter, insbesondere über den Übergangswiderstand des mindestens einen Schließkontaktes treffen. Das stromreduzierende Element begrenzt den Strom auf ein zu Messzwecken geeignetes Maß. Die erfolgte Verbindung wird so über den eingeprägten Messstrom direkt und aussagekräftig vermessen und nicht anhand einer Stellung von Hilfskontakten nur indirekt bestimmt.

Indem der Stromsensor innerhalb des Strompfades in Reihenschaltung zu dem mindestens einen Schließkontakt und zwischen dem Erdungsleiter und dem Neutralleiter angeordnet ist, misst er direkt und unmittelbar den über den mindestens einen Schließkontakt fließenden Strom. In dieser Anordnung wird er allerdings auch bei einem einen Kurzschluss zwischen dem mit Spannung beaufschlagten Leiter und dem Erdungsleiter mit einem gegebenenfalls hohen Kurzschlussstrom belastet. Um einen entsprechenden Fehlerfall unbeschadet überstehen zu können, muss der Stromsensor in der Lage sein, den Kurzschlussstrom zu tragen. Aus Sicherheitsgründen muss er daher auf den jeweiligen Kurzschlussstrom ausgelegt werden. Der Stromsensor kann jedoch auch innerhalb des Strompfades in Reihenschaltung zu dem stromreduzierenden Element und zwischen dem mit Spannung beaufschlagten Leiter und dem Erdungsleiter angeordnet sein. Auch in dieser Anordnung misst der Stromsensor den in dem Strompfad fließenden Strom. Im Gegensatz zur vorherigen Anordnung wird er hier jedoch nicht durch einen Kurzschlussstrom belastet, der bei einem Kurzschluss zwischen dem mit Spannung beaufschlagten Leiter und dem Erdungsleiter hervorgerufen wird. Er muss somit in dieser Anordnung auch nicht für den entsprechenden Kurzschlussstrom ausgelegt werden. In beiden Fällen ist der Stromsensor jedoch innerhalb des Strompfades in Reihenschaltung sowohl zu dem stromreduzierenden Element einerseits, als auch zu dem mindestens einen Schließkontakt andererseits angeordnet.

In der Erdungseinrichtung ist in einer Reihenschaltung zu dem stromreduzierenden Element ein weiterer Schließkontakt angeordnet. Bevorzugt sind der mindestens eine Schließkontakt und der weitere Schließkontakt gemeinsam betätigte Kontakte der Schalteinrichtung. Durch den weiteren Schließkontakt wird ein dauerhaft fließender Strom durch das stromreduzierende Element unterbunden. Wenn der mindestens eine Schließkontakt und der weitere Schließkontakt gemeinsam betätigte Kontakte der Schalteinrichtung sind, fließt ohne weitere Maßnahmen der Messstrom genau dann, wenn der Erdungsleiter mit dem Neutralleiter verbunden werden soll.

In einer weiteren vorteilhaften Ausgestaltung der Erdungseinrichtung ist parallel zu dem mindestens einen Schließkontakt aus Redundanzgründen ein zweiter Schließkontakt parallel geschaltet. Besonders vorteilhaft sind der zweite Schließkontakt und der mindestens eine Schließkontakt gemeinsam betätigte Kontakte der Schalteinrichtung.

In einer weiteren vorteilhaften Ausgestaltung der Erdungseinrichtung ist das stromreduzierende Element ein Kondensator. Auf diese Weise fließt in dem Strompfad im Wesentlichen lediglich ein Blind- und kein Wirkstrom. Der Stromfluss ist damit nicht verlustbehaftet. Weiter bevorzugt ist parallel zu dem Kondensator ein Hilfskontakt der Schalteinrichtung verschaltet. Der Hilfskontakt, insbesondere ein Spiegelkontakt, schließt, wenn die Hauptkontakte der Schalteinrichtung, also der mindestens eine Schließkontakt und der weitere Schließkontakt und ggf. der zweite Schließkontakt, geöffnet sind. In diesem Betriebszustand, in dem kein Strom im Strompfad fließt, wird so der Kondensator aus Sicherheitsgründen entladen. Er stellt dann z.B. bei Wartungseinsätzen kein Gefahrenpotential dar.

In einer weiteren vorteilhaften Ausgestaltung der Erdungseinrichtung ist in einer Reihenschaltung zu dem mindestens einen Schließkontakt und/oder zu dem stromreduzierenden Element eine Sicherung angeordnet. Bevorzugt ist diese Sicherung zwischen dem Leiter und dem Erdungsleiter angeordnet. Die in dem Strompfad angeordnete Sicherung verhindert einen dauerhaften Kurzschlussstrom zwischen dem Leiter und dem Neutralleiter falls das stromreduzierende Element, also beispielsweise der genannte Kondensator, einen internen Kurzschluss aufweist.

In einer weiteren vorteilhaften Ausgestaltung der Erdungseinrichtung weist diese eine Überwachungsschaltung auf, die dazu eingerichtet ist, mit Hilfe des Stromsensors einen Stromfluss über den mindestens einen Schließkontakt der Schalteinrichtung zu überwachen. Zusätzlich kann die Überwachungsschaltung dazu eingerichtet sein, einen Hilfskontakt der Schalteinrichtung zu überwachen.

Eine erfindungsgemäße Netzersatzanlage zum wahlweisen Betreiben einer Verbraucheranordnung an einem Energieversorgungsnetz oder an einer lokalen Energieerzeugungseinrichtung unter Trennung vom Energieversorgungsnetz zeichnet sich durch eine derartige Erdungseinrichtung aus. Bevorzugt ist die Netzersatzanlage dazu eingerichtet, die Verbraucheranordnung von der lokalen Energieerzeugungseinrichtung zu trennen, wenn über den mindestens einen Schließkontakt der Schalteinrichtung kein Strom fließt oder ein Strom fließt, der kleiner als ein vorgegebener Stromschwellenwert ist. Es ergeben sich die im Zusammenhang mit der Erdungseinrichtung genannten Vorteile.

In einer vorteilhaften Ausgestaltung der Netzersatzanlage ist vorgesehen, dass die Erdungseinrichtung den Neutralleiter der Verbraucheranordnung mit dem Erdungsleiter verbindet, wenn die Verbraucheranordnung von dem Energieversorgungsnetz getrennt ist. Auf diese Weise wird eine doppelte Erdung - über das Energieversorgungsnetz und lokal - verhindert, die eventuell zum Auslösen einer Fehlerstromschutzeinrichtung (RCD - Residual Current protective Device) führen könnte. Alternativ ist es möglich, eine doppelte Erdung zuzulassen, wenn der Zeitraum der doppelten Erdung begrenzt ist und bevorzugt kürzer als 0,1 Sekunde ist.

Ein Verfahren zum Betrieb einer erfindungsgemäßen Netzersatzanlage zum wahlweisen Betreiben einer Verbraucheranordnung an einem Energieversorgungsnetz oder an einer lokalen Energieerzeugungseinrichtung unter Trennung vom Energieversorgungsnetz weist die folgenden Schritte auf:
- Verbinden des Neutralleiters der Verbraucheranordnung mit dem Erdungsleiter über den mindestens einen Schließkontakt der Schalteinrichtung, wenn die Verbraucheranordnung mit der lokalen Energieerzeugungseinrichtung betrieben werden soll,
- Bereitstellen eines Strompfades, der ausgehend von einem mit Spannung beaufschlagten Leiter über den Erdungsleiter zu dem Neutralleiter führt, durch Verbinden des gegenüber dem Neutralleiter mit Spannung beaufschlagten Leiters mit dem Erdungsleiter über ein stromreduzierendes Element,
- Detektion eines in dem Strompfad fließenden Stroms über einen Stromsensor, der innerhalb des Strompfades in einer Reihenschaltung zu dem mindestens einen Schließkontakt und/oder zu dem stromreduzierenden Element angeordnet ist,
- Vergleich des über den Stromsensor fließenden Stroms mit einem vorgegebenen Stromschwellenwert, und
- Signalisieren einer nicht vorhandenen und/oder nicht korrekt vorhandenen Verbindung des Neutralleiters der Verbraucheranordnung mit dem Erdungsleiter, wenn kein Strom über den Stromsensor fließt oder der über den Stromsensor fließende Strom kleiner als der vorgegebene Stromschwellenwert ist.

Ein Signalisieren im Sinne der vorliegenden Anmeldung kann jegliche Art einer Kennzeichnung eines nicht ordnungsgemäßen Zustandes der Netzersatzanlage umfassen. Insbesondere kann das Signalisieren über optische (z.B. über eine Warnleuchte), akustische (z.B. über einen Signalton), elektronische und/oder nachrichtentechnische Mittel (z.B. über ein Versenden einer Nachricht an den Betreiber der Netzersatzanlage) erfolgen. Gleichfalls umfasst das Signalisieren im Sinne der Anmeldung auch eine Änderung des Betriebszustandes der Netzersatzanlage, da auch dieser von dem Betreiber der Netzersatzanlage prinzipiell wahrgenommen wird und somit den nicht ordnungsgemäßen Zustand der Netzersatzanlage kennzeichnet.

In einer vorteilhaften Ausführungsform des Verfahrens bewirkt das Signalisieren einer nicht vorhandenen und/oder nicht korrekt vorhandenen Verbindung des Neutralleiters der Verbraucheranordnung mit dem Erdungsleiter eine Unterdrückung des Energieflusses von der lokalen Energieerzeugungseinrichtung zu der Verbraucheranordnung. Hierdurch erfolgt nicht nur eine Signalisierung bzw. Kennzeichnung des nicht ordnungsgemäßen Zustandes der Netzersatzanlage, sondern vielmehr auch eine Einleitung einer Schutzmaßnahme in Reaktion auf diesen Zustand. Insbesondere wird, indem der Energiefluss der lokalen Energieerzeugungseinrichtung zu der Verbraucheranordnung unterdrückt wird, eine Personengefährdung durch die Netzersatzanlage verhindert.

Der Energiefluss der lokalen Energieerzeugungseinrichtung zu der Verbraucheranordnung kann beispielsweise über eine Deaktivierung von Brückenschaltern eines der lokalen Energieerzeugungsanlage zugeordneten Batteriewechselrichters erfolgen. In diesem Beispiel ist eine an den Batteriewechselrichter angeschlossene Batterie - und somit auch die lokale Energieerzeugungseinrichtung an sich - weiterhin galvanisch mit der Verbraucheranordnung verbunden. Ein Energiefluss wird jedoch über die deaktivierten - i.e. geöffneten Brückenschalter - unterdrückt. In einer weiteren Ausführungsform des Verfahrens hingegen erfolgt die Unterdrückung des Energieflusses von der lokalen Energieerzeugungseinrichtung zu der Verbraucheranordnung dadurch, dass die lokale Energieerzeugungseinrichtung von der Verbraucheranordnung galvanisch getrennt wird. Dies kann beispielsweise über ein Öffnen einer elektromechanischen Schalteinrichtung erfolgen, die die lokale Energieerzeugungsanlage mit der Verbraucheranordnung verbindet. Ein galvanisches Trennen kann auch kumulativ zur oben beschriebenen Deaktivierung der Brückenschalter des Batteriewechselrichters vorgenommen werden.

Nachfolgend wird die Erfindung anhand von Ausführungsbeispielen mithilfe von zwei Figuren näher erläutert.

Die Figuren zeigen:
- Fig. 1: ein Blockschaltbild einer Erdungseinrichtung und
- Fig. 2: ein Blockschaltbild einer Netzersatzanlage mit einer Erdungseinrichtung gemäß Figur 1.

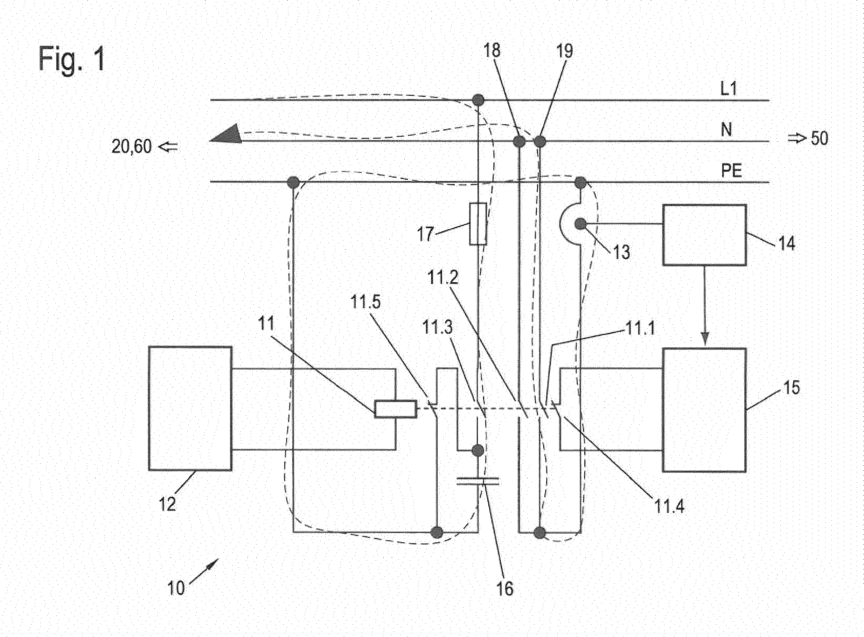

Fig. 1 zeigt in einem Blockschaltbild ein Ausführungsbeispiel einer Erdungseinrichtung 10 für eine Netzersatzanlage. Die Netzersatzanlage stellt im regulären Netzbetrieb, der auch als Netzparallelbetrieb bezeichnet wird, eine Verbindung zwischen einem Energieversorgungsnetz 20 und einer Verbraucheranordnung 50 her. Bei einem Ausfall des Energieversorgungsnetzes 20 wird - sofern nicht auch in einem Netzparallelbetrieb schon vorhanden - eine Verbindung zwischen der Verbraucheranordnung 50 sowie einer lokalen Energieversorgungseinrichtung 60 hergestellt. Bei der lokalen Energieversorgungseinrichtung handelt es sich vorteilhafterweise um einen an eine Batterie angeschlossenen Batteriewechselrichter. Zusätzlich oder alternativ kann die lokale Energieversorgungseinrichtung andere energieerzeugende Komponenten, wie z. B. einen Generator, eine Photovoltaik (PV) - Anlage und/oder eine Brennstoffzelle aufweisen.

Die Erdungseinrichtung 10 weist Anschlüsse auf, mit denen sie an stromführenden Leitungen, hier beispielhaft an einen Leiter L1 und einen Neutralleiter N innerhalb der Netzersatzanlage angeschlossen ist. Weiterhin kontaktieren die Anschlüsse der Erdungseinrichtung einen Erdungsleiter PE, der zumindest mit einem lokalen Erdanschluss verbunden ist.

Das Energieversorgungsnetz 20, die Verbraucheranordnung 50 und die lokale Energieversorgungseinrichtung 60 sind aus Gründen der Übersichtlichkeit in dieser Figur nicht dargestellt. Mit Pfeilen ist lediglich die Verbindung der Erdungseinrichtung 10 mit dem Energieversorgungsnetz 20 bzw. der lokalen Energieversorgungseinrichtung 60 (nach links) und der Verbraucheranordnung 50 (nach rechts) im Bereich des Neutralleiters N, des Leiters L1 und des Erdungsleiters PE angedeutet.

Beispielhaft ist die Verbindung zwischen dem Energieversorgungsnetz 20 bzw. der lokalen Energieversorgungseinrichtung 60 und der Verbraucheranordnung 50 in der Fig. 1 einphasig mit nur einem Leiter L1 dargestellt. Es versteht sich, dass anstelle der angegebenen einphasigen Ausführung auch das Energieversorgungsnetz 20, die lokale Energieversorgungseinrichtung 60 und/oder die Verbraucheranordnung 50 sowie deren Verbindung mehrphasig und insbesondere dreiphasig ausgelegt sein kann.

Im regulären Netzbetrieb ist der dargestellte Neutralleiter N durch das Energieversorgungsnetz 20 mit dem Erdungsleiter PE verbunden. Bei einem Netzausfall liegt diese Verbindung nicht mehr gesichert vor. Zudem werden spätestens bei einem Aufschalten der lokalen Energieversorgungseinrichtung 60 auf die Verbraucheranordnung 50 üblicherweise sowohl der Leiter L1, als auch der Neutralleiter N über eine Trennstelle von dem Energieversorgungsnetz 20 abgetrennt. Dies verhindert in sicherer Weise einen Energiefluss seitens der lokalen Energieversorgungseinrichtung 60 in einen im Energieversorgungsnetz 20 vorhandenen Fehler, führt jedoch auch dazu, dass die Verbindung zwischen dem Neutralleiter N und dem Erdungsleiter PE auf der dem Energieversorgungsnetz 20 abgewandten Seite der Trennstelle unterbrochen ist.

Im in Fig. 1 dargestellten Fall erfolgt ein Betrieb der Verbraucheranordnung 50 über die lokale Energieversorgungseinrichtung 60 in Form eines TN-Netzes. Hier ist jedoch aus Sicherheitsgründen eine niederimpedante Verbindung zwischen dem Neutralleiter N und dem Erdungsleiter PE sicherzustellen. Die in Fig. 1 gezeigte Erdungseinrichtung 10 dient zum einen dem Herstellen der genannten Verbindung zwischen dem Neutralleiter N und dem Erdungsleiter PE sowie der Überwachung, dass diese Verbindung auch wirksam, insbesondere ausreichend niederimpedant, hergestellt ist.

Zum Herstellen der Verbindung zwischen dem Neutralleiter N und dem Erdungsleiter PE weist die Erdungseinrichtung 10 eine Schalteinrichtung 11 auf, die von einer Ansteuerschaltung 12 angesteuert wird. Die Ansteuerschaltung 12 umfasst selbst eine Netzüberwachungseinrichtung oder ist mit einer Netzüberwachungseinrichtung verbunden, die das Energieversorgungsnetz 20 auf seine reguläre Funktion hin überwacht. Fällt das Energieversorgungsnetz 20 ganz oder im Hinblick auf einen Teil seiner Phasen aus, steuert die Ansteuerschaltung 12 die Schalteinrichtung 11 an. Die Schalteinrichtung 11 ist bevorzugt ein handelsübliches Schütz mit drei gemeinsam betätigten Schließkontakten 11.1, 11.2, 11.3. Zudem sind Hilfskontakte 11.4 und 11.5 vorhanden, die von ihrer Funktion her Öffnerkontakte, insbesondere sogenannte Spiegelkontakte, sind. Die als Spiegelkontakte ausgeführten Hilfskontakte 11.4 und 11.5 sind derartig zwangsgeführt, dass sie nur dann geschlossen sind, wenn sämtliche Schließkontakte 11.1-11.3 geöffnet sind. Insofern zeigen geschlossene, als Spiegelkontakte ausgeführte Hilfskontakte 11.4 bzw. 11.5 sicher an, dass über die Erdungseinrichtung 10 keine Verbindung zwischen dem Neutralleiter N und dem Erdungsleiter PE besteht. Hingegen lässt sich aus geöffneten Hilfskontakten 11.4 bzw. 11.5, die als Spiegelkontakte ausgeführt sind, keine sichere Information über einen Schaltzustand der entsprechenden Schließkontakte 11.1 - 11.3 ableiten. Die Schließkontakte 11.1-11.3 sind typischerweise für eine hohe Stromtragfähigkeit ausgerichtet, wohingegen die Hilfskontakte 11.4 und 11.5 lediglich zu Überwachungszwecken dienen. Eine Schalteinrichtung 11 mit der genannten Anzahl von drei Arbeits- und zwei Hilfskontakten ist in der Installationstechnik ein verbreitetes und entsprechend kostengünstiges Bauteil. Es wird angemerkt, dass das erfindungsgemäße Verfahren prinzipiell bereits mit einer Schalteinrichtung mit nur einem Schließkontakt, nämlich einem der Schließkontakte 11.1 oder 11.2, durchgeführt werden kann.

Über mindestens einen, vorliegend zwei parallel geschaltete Schließkontakte 11.1 und 11.2 ist der Neutralleiter N mit dem Erdungsleiter PE verbunden. Die beiden Schließkontakte 11.1 und 11.2 sind parallel geschaltet, um eine redundante Verbindung auch beim Ausfall oder bei Kontaktproblemen eines der Schließkontakte 11.1 bzw. 11.2 sicherzustellen. In der Verbindung zwischen dem Neutralleiter N und dem Erdungsleiter PE über die Schließkontakte 11.1 und 11.2 ist weiter ein Stromsensor 13 angeordnet, der einen Stromfluss durch die genannte Verbindung mithilfe einer Auswerteschaltung 14 detektieren kann. Der Stromsensor 13 kann beispielsweise ein Shunt oder ein Hall-Sensor oder eine Induktionsschleife- bzw. Spule sein.

Wird ein Stromfluss oberhalb eines bestimmten Stromschwellenwerts am Stromsensor 13 erkannt, übermittelt die Auswerteschaltung 14 ein entsprechendes Signal an eine Überwachungsschaltung 15, deren Funktion im weiteren Verlauf näher erläutert wird.

Über den verbleibenden dritten Schließkontakt 11.3 der Schalteinrichtung 11 wird der Erdungsleiter PE über einen Kondensator 16 als stromreduzierendes Element und eine optionale Sicherung 17 mit dem Leiter L1 verbunden. Bei betätigter Schalteinrichtung 11, das heißt geschlossenen Schließkontakten 11.1 - 11.3, fließt zwischen dem Leiter L1 und dem Neutralleiter ein Strom, dessen Strompfad durch die gestrichelte Linie in Fig. 1 angegeben ist. Ausgehend von dem Leiter L1 führt der Strompfad über die Sicherung 17, den geschlossenen Schließkontakt 11.3, den Kondensator 16, die Erdungsleitung PE, den Stromsensor 13 und die beiden parallel geschalteten geschlossenen Schließkontakte 11.1 und 11.2 zum Neutralleiter N. Der Stromsensor 13 ist somit innerhalb des Strompfades in Reihenschaltung zu dem Schließkontakt 11.1 - bzw. zu der Parallelschaltung der Schließkontakte 11.1, 11.2 einerseits und/oder in Reihenschaltung zu dem weiteren Schließkontakt 11.3 andererseits angeordnet. Der Kondensator wirkt als strombegrenzendes Element in dem Strompfad. Die Höhe des fließenden Stroms wird durch die Kapazität des Kondensators 16 festgelegt. Zudem führt der Kondensator 16 dazu, dass im dargestellten Strompfad im Wesentlichen lediglich ein Blind- und kein Wirkstrom fließt. Der Stromfluss ist also im Wesentlichen nicht verlustbehaftet.

Im dargestellten Strompfad kann nur dann Strom fließen, wenn der Schließkontakt 11.3 und zumindest einer der Schließkontakte 11.1 oder 11.2 korrekt geschlossen sind. Der Stromfluss bei geschlossenen Schließkontakten, insbesondere bei geschlossenem Schließkontakt 11.1 oder 11.2 wird vom Stromsensor 13 detektiert und von der Auswerteschaltung 14 in ein Stromsignal gewandelt, das an die Überwachungsschaltung 15 weiter gegeben wird. Der Strompfad stellt somit einen Messstromkreis für einen Messstrom dar, mit dem der Zustand der Schließkontakte 11.1 oder 11.2 unmittelbar ausgemessen werden kann. In einer alternativen Ausgestaltung der Erdungseinrichtung kann die Auswerteschaltung 14 auch in der Überwachungsschaltung 15 integriert sein.

Zudem wertet die Überwachungsschaltung 15 einen der Hilfskontakte des Schalteinrichtung 11, vorliegend den Hilfskontakt 11.4 aus. In der folgenden Erklärung werden als Spiegelkontakte ausgeführte Hilfskontakte 11.4 bzw. 11.5 vorausgesetzt. Während nun ein geschlossener Hilfskontakt 11.4 sicher anzeigt, dass über die Erdungseinrichtung 10 keine Verbindung zwischen Neutralleiter N und Erdungsleiter PE hergestellt ist, so liefert im vorliegenden Fall der geöffnete Hilfskontakt 11.4 weder eine Aussage darüber, welchen Schaltzustand die entsprechenden Schließkontakte 11.1 - 11.3 der Schalteinrichtung einnehmen, noch liefert er eine sichere Aussage darüber, ob über die Erdungseinrichtung 10 eine korrekte Verbindung zwischen Neutralleiter N und Erdungsleiter PE hergestellt ist. So ist es beispielsweise möglich, dass einzelne Schließkontakte, z.B. 11.1 und 11.2, noch geöffnet sind. Auch kann es sein, dass zwar alle Schließkontakte 11.1 bis 11.3 betätigt sind, aber insbesondere die Schließkontakte 11.1 und 11.2 einen nicht ausreichend niederimpedanten Übergangswiderstand aufweisen. Der geöffnete Hilfskontakt 11.4 liefert daher keine gesicherte Information darüber, ob die Schließkontakte 11.1 und 11.2 auch korrekt eine Verbindung zwischen Neutralleiter N und Erdungsleiter PE herstellen, das heißt, ob der Übergangswiderstand der geschlossenen Schließkontakte 11.1 und 11.2 ausreichend niederimpedant ist. Die korrekte Verbindung wird der Überwachungsschaltung 15 jedoch aufgrund des Stromsignals der Auswerteschaltung 14 signalisiert, welches den vom Stromsensor 13 detektierten Strom repräsentiert.

In der Überwachungsschaltung 15 wird das Stromsignal, welches den vom Stromsensor 13 detektierten Strom repräsentiert, mit dem dort hinterlegten Stromschwellenwert verglichen. Überschreitet der vom Stromsensor 13 detektierte Strom den Stromschwellenwert, so ist davon auszugehen, dass korrekt geschlossene Schließkontakte 11.1 und 11.2 mit ausreichend niederimpedanten Übergangswiderständen, zumindest jedoch ein korrekt geschlossener Schließkontakt 11.1 oder 11.2 mit einem ausreichend niederimpedanten Übergangswiderstand, vorliegt. Wenn nun entweder der Hilfskontakt 11.4 geschlossen ist und damit anzeigt, dass keiner der beiden Schließkontakte 11.1 bzw. 11.2 geschlossen ist und/oder kein ausreichend großes Stromsignal an die Überwachungsschaltung 15 übermittelt wird, so ist von einer nicht ordnungsgemäßen Verbindung zwischen dem Neutralleiter N und dem Erdungsleiter PE auszugehen.

Eine nicht ordnungsgemäße wie auch eine ordnungsgemäße Verbindung zwischen Neutralleiter N und Erdungsleiter PE wird von der Überwachungsschaltung 15 entsprechend signalisiert. Das Signal kann von weiteren Komponenten der Netzersatzanlage ausgewertet werden. So kann erreicht werden, dass die lokale Energieversorgungseinrichtung 60 entweder gar nicht an die Verbraucheranordnung 50 angekoppelt wird oder wieder von ihr getrennt wird, wenn der Neutralleiter N nicht gesichert geerdet ist.

Die Kapazität des Kondensators 16 wird bevorzugt so gewählt, dass ein Stromfluss im dargestellten Strompfad sicher vom Stromsensor 13 und der Auswerteschaltung 14 detektiert werden kann. Der Stromfluss ist bevorzugt nicht zu klein gewählt, um Anforderungen im Hinblick auf Empfindlichkeit und Störsicherheit an dem Stromsensor 13 und der Auswerteschaltung 14 nicht unnötig groß werden zu lassen. Der Strom sollte jedoch auch nicht zu hoch gewählt werden, um eine unnötige Blindstromlast zu vermeiden. Die in dem Strompfad angeordnete Sicherung 17 verhindert einen Kurzschluss zwischen dem Leiter L1 und dem Neutralleiter N falls beispielsweise der Kondensator 16 einen internen Kurzschluss zeigt. Eine ausgelöste Sicherung 17 wird von der Überwachungsschaltung 15 erkannt, da bei ausgelöster Sicherung 17 kein Stromfluss mehr vom Stromsensor 13 detektiert werden kann und dies der Überwachungseinheit durch ein entsprechendes Stromsignal übermittelt wird.

Der noch verbleibende zweite Hilfskontakt 11.5 der Schalteinrichtung 11 ist in der dargestellten Ausgestaltung der Erdungseinrichtung 10 parallel zum Kondensator 16 geschaltet. Auf diese Weise wird der Kondensator 16 bei nicht betätigter Schalteinrichtung 11 aus Sicherheitsgründen entladen. Dieses ist optional und für die Funktionalität der Erdungseinrichtung 10 und der Überwachung nicht erforderlich.

In Fig. 1 ist die Erdungseinrichtung 10 am Beispiel einer Schalteinheit 11 mit drei Schließkontakten 11.1 bis 11.3 dargestellt. Diese weist aus Sicherheitsgründen (ggf. auch aus Verfügbarkeitsgründen) mit den Schließkontakten 11.1 und 11.2 eine redundante, doppelt ausgeführte Verbindung zwischen Neutralleiter N und Erdungsleiter PE auf. Erfindungsgemäß ist auch eine Schalteinrichtung 11 mit lediglich zwei Schließkontakten, z. B. 11.2 und 11.3 ausreichend. Allerdings hat die redundante Variante mit zwei parallel geführten Verbindungen zwischen Neutralleiter N und Erdungsleiter PE noch einen weiteren Vorteil. So wird bei Versorgung der Verbrauchsanordnung 50 über die lokale Energieversorgungseinrichtung 60 ein Teil des insgesamt in dem Neutralleiter N fließenden Stromes über die geschlossenen Schließkontakte 11.1 und 11.2 geführt. Dieser Anteil ist abhängig von einer Impedanz des Neutralleiters N zwischen den Anschlusspunkten 18 und 19 relativ zur Impedanz eines Strompfades entlang der geschlossenen Schließkontakte 11.1, 11.2. Ein stärkerer Stromfluss bewirkt hier vorteilhafterweise eine Selbstreinigung der Schließkontakte 11.1, 11.2 und wirkt somit einer altersbedingten Degeneration derselben, z.B. aufgrund von Oxidationsprozessen, entgegen.

In Fig. 1 sind die Schließkontakte 11.1 bis 11.3 und die Hilfskontakte 11.4, 11.5 Bestandteil nur einer Schalteinrichtung 11. Erfindungsgemäß können jedoch die Schließkontakte 11.1 bis 11.3 und die Hilfskontakte 11.4, 11.5 auch in mehreren, beispielsweise zwei separaten Schalteinrichtungen lokalisiert sein. So kann beispielsweise eine erste Schalteinheit den Schließkontakt 11.1, den Hilfskontakt 11.4 und optional den Schließkontakt 11.2 aufweisen, während eine zweite Schalteinheit den Schließkontakt 11.3 und den Hilfskontakt 11.5 enthält. In diesem Fall reagieren die Hilfskontakte 11.4, 11.5 beider Schalteinrichtungen wie auch die entsprechenden Schließkontakte unabhängig voneinander.

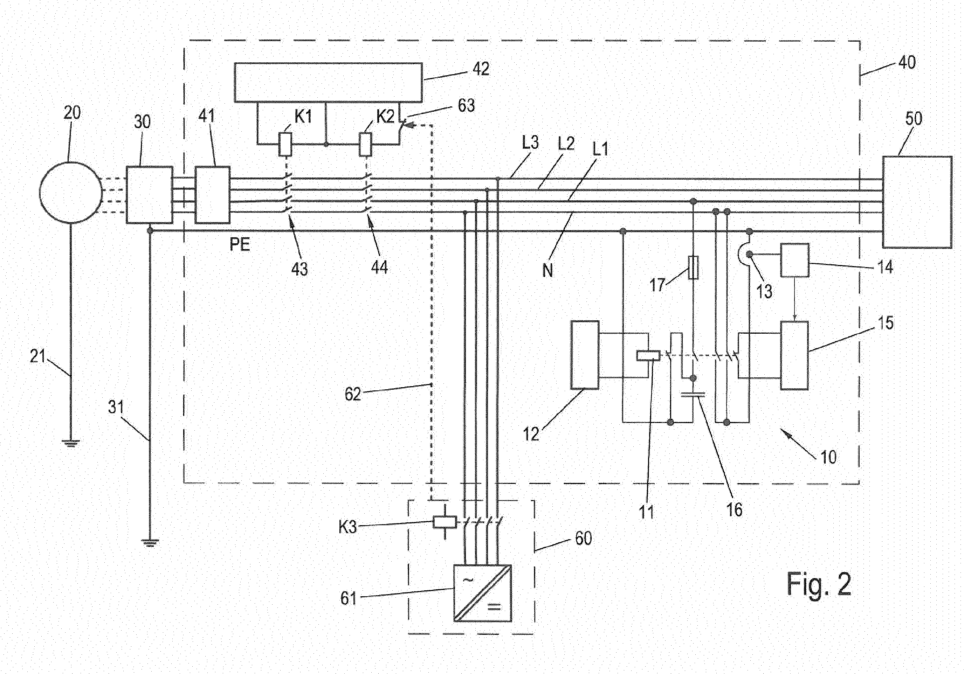

Fig. 2 zeigt ein Blockschaltbild einer Netzersatzanlage mit einer anmeldungsgemäßen Erdungseinrichtung. Gleiche Bezugszeichen kennzeichnen dabei gleiche oder gleichwirkende Elemente wie in Fig. 1.

Die Netzersatzanlage ist an ein übergeordnetes Energieversorgungsnetz 20 angeschlossen, das hier beispielhaft die Topologie eines TT-Netzes aufweist, das keine separate Erdungsleitung als Schutzleiter bereitstellt. Stattdessen ist im Energieversorgungsnetz 20 an geeigneter Stelle ein Neutralleiter N des Energieversorgungsnetzes 20 mit einem Erdungsanschluss 21 verbunden, um eine Erdung des Neutralleiters N bereitzustellen. Die anmeldungsgemäße Erdungseinrichtung kann ebenso im Zusammenhang mit einem Energieversorgungsnetz mit anderer Topologie, wie z.B. einem TN Netz, insbesondere einem TN-S, TN-C oder einem TN-C-S Netz eingesetzt werden.

In einem Hausanschlussbereich 30 ist ein lokaler Erdungsanschluss 31 vorgesehen, der einen Erdungsleiter PE, beispielsweise zur Erdung von Verbrauchern, bereitstellt. Im Folgenden wird das Potential am lokalen Erdungsanschluss 31 und dem Erdungsleiter PE als Erdpotential bezeichnet. Der Hausanschluss 30 ist über eine Umschalteinrichtung 40 sowohl mit einer Verbraucheranordnung 50, als auch mit einer lokalen Energieversorgungseinrichtung 60 verbunden. Die Umschalteinrichtung 40 weist in dem gezeigten Beispiel einen optionalen Energiezähler 41 auf, an dessen Ausgang drei Leiter L1, L2, L3, auch Phasen genannt, und ein Neutralleiter N des Energieversorgungsnetzes 20 bereitgestellt werden. Die drei Leiter L1 bis L3 sowie der Neutralleiter N sind mit entsprechenden Leitern der Verbraucheranordnung 50 über Schaltkontakte 43 und 44 verbunden. Die Schaltkontakte sind jeweils Schließkontakte (Arbeitskontakte) von zwei Schalteinrichtungen K1 und K2, beispielsweise von Schützen. Das Vorsehen von jeweils zwei hintereinandergeschalteten Schaltkontakten 43, 44 erfolgt aus Redundanzgründen, um sicherzustellen, dass eine vollständige Trennung der Verbraucheranordnung 50 vom Versorgungsnetz 20 erfolgt. Zudem ist die Trennung allpolig, das heißt, dass jeder der drei Leiter L1, L2 und L3 sowie der Neutralleiter N unterbrochen werden. Angesteuert werden die Schütze K1 und K2 über eine Steuereinrichtung 42 der Umschalteinrichtung 40. Diese umfasst beispielsweise einen Netzfehlerdetektor, der die Schütze K1 und K2 entsprechend eines Betriebszustandes des Energieversorgungsnetzes 20 betätigt.

Der Neutralleiter N und die Leiter L1, L2 und L3 sind (bezogen auf die Schaltkontakte 43, 44) auf der Seite der Verbraucheranordnung 50 mit einer lokalen Energieversorgungseinrichtung 60 verbunden. Diese umfasst einen Batteriewechselrichter 61, der gleichstromseitig mit einer Batterie als Energiespeicher (in der Figur nicht dargestellt) verbunden ist und wechselstromseitig über eine Schalteinrichtung K3 im Fehlerfall des Energieversorgungsnetzes 20 die Energieversorgung der Verbraucheranordnung 50 übernimmt. Weitere lokale Energieversorgungseinheiten, beispielsweise eine Photovoltaikanlage und/oder ein Generator können zusätzlich zur Energieversorgung im Fehlerfall eingesetzt werden. Anstatt in der Steuereinrichtung 42 kann der Netzfehlerdetektor auch innerhalb der lokalen Energieversorgungseinrichtung 60 vorgesehen sein, insbesondere in dem Batteriewechselrichter 61.

Die lokale Energieversorgungseinrichtung 60 steht über eine Verriegelungsleitung 62 mit der Steuereinrichtung 42 in Verbindung. Über die Verriegelungsleitung 62 kann ein Verriegelungsschalter 63 von der lokalen Energieversorgungseinrichtung 60 geschaltet werden, der auf die Schalteinrichtung K2 wirkt. Neben der drahtgebundenen Verriegelung über die Verriegelungsleitung 62 kann auch eine drahtlose Kommunikation genutzt werden.

Im Normalbetriebszustand des Energieversorgungsnetzes 20, in dem die Schalteinrichtungen K1 und K2 aktiviert und somit alle zugehörigen Schaltkontakte 43, 44 geschlossen sind, ist die Verbraucheranordnung 50 mit dem Versorgungsnetz 20 verbunden. In diesem Betriebszustand kann vorgesehen sein, über eine Ladeeinrichtung Energie aus dem Energieversorgungsnetz 20 zum Aufladen der Energiespeicher der lokalen Energieversorgungseinrichtung 60 zu beziehen. Gleichfalls ist im Netzparallelbetrieb auch ein Entladen der Batterie und eine Stromeinspeisung in das Energieversorgungsnetz 20, z.B. aus Gründen des Energiemanagements oder zwecks einer Stützung des Energieversorgungsnetzes 20, möglich. Um das Auf- und Entladen der Batterie zu gewährleisten, ist der Batteriewechselrichter 61 vorteilhafterweise so ausgelegt, dass er bidirektional betrieben werden kann.

In dem Normalbetriebszustand des Energieversorgungsnetzes 20 ist zudem die Schalteinrichtung 11 der Erdungseinrichtung 10 nicht geschaltet, so dass durch die Erdungseinrichtung 10 keine lokale Verbindung zwischen dem Neutralleiter N und dem Erdungsleiter PE hergestellt wird. Eine Verbindung des Neutralleiters N mit dem Erdungsleiter PE ist durch das Energieversorgungsnetz 20 gegeben. Eine sichere Information, dass die Erdungseinrichtung 10 keine lokale Verbindung zwischen Neutralleiter N und Erdungsleiter PE hergestellt hat, kann beispielsweise über eine Abfrage der als Spiegelkontakte ausgelegten Hilfskontakte 11.4 bzw. 11.5 der Schalteinrichtung 11 erfolgen. Wie bereits erwähnt, sind die als Spiegelkontakt ausgeführten Hilfskontakte einer Schalteinrichtung - hier der Schalteinrichtung 11 mit den Hilfskontakten 11.4, 11.5 - nur dann geschlossen, wenn alle Schließkontakte der entsprechenden Schalteinrichtung - hier die Schließkontakte 11.1, 11.2 und 11.3 - sicher geöffnet sind. Auf diese Weise kann von der den Hilfskontakt 11.4 überwachenden Überwachungseinheit 15 auch angezeigt werden, dass alle Schließkontakte 11.1 - 11.3 geöffnet sind. Daher lässt sich ein Betrieb der Verbraucheranordnung 50 über das Energieversorgungsnetz 20 bei gleichzeitig vorhandener (normativ unzulässiger) lokaler Verbindung zwischen Neutralleiter N und Erdungsleiter PE über eine Abfrage des Hilfskontaktes 11.4 sicher ausschließen. Dies lässt sich sinngemäß auch auf einen Fall übertragen, bei dem die Hilfskontakte 11.4, 11.5, wie auch die entsprechenden Schließkontakte 11.1, 11.3 und optional 11.2 in mehreren separaten, beispielsweise in zwei Schalteinrichtungen lokalisiert sind. Bei einem Ausfall des Energieversorgungsnetzes 20 werden die Schalteinrichtungen K1 und K2 deaktiviert und die Verbraucheranordnung 50 wird von dem Energieversorgungsnetz 20 getrennt. Von der Ansteuerschaltung 12 wird zudem die Schalteinrichtung 11 betätigt, die eine lokale Verbindung zwischen dem Neutralleiter N und dem Erdungsleiter PE herstellt. Die Ansteuerschaltung 12 ist dazu ebenfalls mit dem Netzfehlerdetektor verbunden. Unmittelbar nach Betätigung der Schalteinrichtung 11, d.h. dem Schließen der Schließkontakte 11.1 - 11.3, wird von der Überwachungseinrichtung 15 fortlaufend ein Stromfluss durch den Stromsensor 13 überwacht. Wird kein oder ein nicht ausreichend hoher Strom unterhalb des Stromschwellenwertes detektiert, so kann eine korrekte Verbindung zwischen Neutralleiter N und Erdungsleiter PE nicht sicher vorausgesetzt werden. Ursache der nicht korrekten Verbindung können beispielsweise fehlerhafte Schließkontakte 11.1 und 11.2 sein, die im geschlossenen Zustand einen nicht ausreichend niederimpedanten Übergangswiderstand aufweisen. Entsprechend wird ein Leistungsfluss von der lokalen Energieversorgungseinrichtung 60 in Richtung der Verbraucheranordnung 50 unterbunden. Dies kann dadurch erfolgen, dass die Halbleiterschalter des Batteriewechselrichters 61 deaktiviert werden. Zusätzlich oder alternativ hierzu kann die lokale Energieversorgungseinrichtung 60 auch über ein Deaktivieren der Schalteinrichtungen K3 von der Verbraucheranordnung 50 getrennt werden.

Bei einer Wiederkehr des Energieversorgungsnetzes 20 erfolgt zunächst eine Synchronisation des Inselnetzes, das die lokale Energieversorgungseinrichtung 60 bereitstellt mit dem Energieversorgungsnetz 20. Danach wird über die Ansteuerschaltung 12 die Schalteinrichtung 11 abgeschaltet und die lokale Verbindung zwischen dem Neutralleiters N mit dem Erdungsleiter PE wieder unterbrochen. Anschließend werden durch Ansteuern der Schalteinrichtungen K1 und K2 die Schaltkontakte 43 und 44 geschlossen und somit die Verbindung zum Energieversorgungsnetz 20 wieder hergestellt. Alternativ dazu ist es auch möglich, nach der Synchronisation des Inselnetzes zunächst die Schaltkontakte 43 und 44 zu schließen und dann erst die lokale Verbindung zwischen dem Neutralleiters N mit dem Erdungsleiter PE zu unterbrechen. Der Zustand, in dem die Verbraucheranordnung 50 mit dem Energieversorgungsnetz 20 verbunden ist und gleichzeitig noch die lokale Verbindung zwischen dem Neutralleiter N und dem Erdungsleiter PE besteht, ist dabei jedoch bevorzugt kurz zu halten, insbesondere kürzer als etwa 0,1 Sekunde. Der Übergang zur Versorgung der Verbraucheranordnung 50 von der lokalen Energieversorgungseinrichtung 60 auf das Energieversorgungsnetz 20 erfolgt in beiden Fällen unterbrechungsfrei.

### Bezugszeichenliste

- 10: Erdungseinrichtung
- 11: Schalteinrichtung
- 11.1: Schließkontakt
- 11.2: Schließkontakt
- 11.3: Schließkontakt
- 11.4: Hilfskontakt
- 11.5: Hilfskontakt
- 12: Ansteuerschaltung
- 13: Stromsensor
- 14: Auswerteschaltung
- 15: Überwachungsschaltung
- 16: Kondensator
- 17: Sicherung
- 18: Anschlusspunkt
- 19: Anschlusspunkt

- 20: Energieversorgungsnetz
- 21: Erdungsanschluss im Energieversorgungsnetz

- 30: Hausanschluss
- 31: lokaler Erdungsanschluss

- 40: Umschalteinrichtung
- 41: Zähler
- 42: Steuereinrichtung
- 43: Schaltkontakte (K1)
- 44: Schaltkontakte (K2)

- 50: Verbraucheranordnung
- 60: lokale Energieversorgungseinrichtung
- 61: Batteriewechselrichter
- 62: Verriegelungsleitung
- 63: Verriegelungsschalter

- K1 bis K3: Schalteinrichtung

- N: Neutralleiter
- L, L1, L2, L3: Leiter
- PE: Erdungsleiter

## Patentansprüche

1. Erdungseinrichtung (10) für eine Netzersatzanlage zum Verbinden eines Neutralleiters (N) einer Verbraucheranordnung (50) mit einem Erdungsleiter (PE) über mindestens einen Schließkontakt (11.1) einer Schalteinrichtung (11), **dadurch gekennzeichnet, dass**
- ein gegenüber dem Neutralleiter (N) mit Spannung beaufschlagter Leiter (L1) über eine Reihenschaltung aus einem stromreduzierenden Element und einem weiteren Schließkontakt (11.3) mit dem Erdungsleiter (PE) schaltbar verbunden ist,
- wobei durch die Verbindung des Erdungsleiters (PE) mit dem mit Spannung beaufschlagten Leiter (L1) über das stromreduzierende Element ein Strompfad gebildet wird, der ausgehend von dem mit Spannung beaufschlagten Leiter (L1) über den Erdungsleiter (PE) zum Neutralleiter (N) führt,
- wobei in dem Strompfad dann ein Strom fließt, wenn der Erdungsleiter (PE) über den mindestens einen Schließkontakt (11.1) mit dem Neutralleiter (N) verbunden ist, und
- wobei innerhalb des Strompfades in einer Reihenschaltung zu dem mindestens einen Schließkontakt (11.1) und/oder zu dem stromreduzierenden Element ein Stromsensor (13) angeordnet ist.

2. Erdungseinrichtung (10) nach Anspruch 1, bei der der mindestens eine Schließkontakt (11.1) und der weitere Schließkontakt (11.3) gemeinsam betätigte Kontakte der Schalteinrichtung (11) sind.

3. Erdungseinrichtung (10) nach einem der Ansprüche 1 bis 2, bei der parallel zu dem mindestens einen Schließkontakt (11.1) aus Redundanzgründen ein zweiter Schließkontakt (11.2) parallel geschaltet ist, und wobei optional der zweite Schließkontakt (11.2) und der mindestens eine Schließkontakt (11.1) gemeinsam betätigte Kontakte der Schalteinrichtung (11) sind.

4. Erdungseinrichtung (10) nach einem der Ansprüche 1 bis 3, bei der das stromreduzierende Element ein Kondensator (16) ist.

5. Erdungseinrichtung (10) nach Anspruch 4, bei der parallel zu dem Kondensator (16) ein Hilfskontakt (11.5) der Schalteinrichtung (11) verschaltet ist.

6. Erdungseinrichtung (10) nach einem der Ansprüche 1 bis 5, bei der in einer Reihenschaltung zu dem mindestens einen Schließkontakt (11.1) und/oder zu dem stromreduzierenden Element eine Sicherung (17) angeordnet ist.

7. Erdungseinrichtung (10) nach Anspruch 6, bei der die Sicherung (17) zwischen dem Leiter (L1) und dem Erdungsleiter (PE) angeordnet ist.

8. Erdungseinrichtung (10) nach einem der Ansprüche 1 bis 7, aufweisend eine Überwachungsschaltung (15), die dazu eingerichtet ist, mit Hilfe des Stromsensors (13) einen Stromfluss über den mindestens einen Schließkontakt (11.1) der Schalteinrichtung (11) zu überwachen.

9. Erdungseinrichtung (10) nach Anspruch 8, wobei die Überwachungsschaltung (15) weiter dazu eingerichtet ist, einen Hilfskontakt (11.4) der Schalteinrichtung (11) zu überwachen.

10. Netzersatzanlage zum wahlweisen Betreiben einer Verbraucheranordnung (50) an einem Energieversorgungsnetz (20) oder an einer lokalen Energieerzeugungseinrichtung (60) unter Trennung vom Energieversorgungsnetz (20), **dadurch gekennzeichnet, dass** die Netzersatzanlage eine Erdungseinrichtung (10) gemäß einem der Ansprüche 1 bis 9 aufweist.

11. Netzersatzanlage nach Anspruch 10, die dazu eingerichtet ist, die Verbraucheranordnung (50) von der lokalen Energieerzeugungseinrichtung (60) zu trennen, wenn über den mindestens einen Schließkontakt (11.1) der Schalteinrichtung (11) kein Strom fließt oder ein Strom fließt, der kleiner als ein vorgegebener Stromschwellenwert ist.

12. Netzersatzanlage nach Anspruch 10 oder 11, bei der die Erdungseinrichtung (10) dazu eingerichtet ist, den Neutralleiter (N) der Verbraucheranordnung (50) mit dem Erdungsleiter (PE) zu verbinden, wenn die Verbraucheranordnung (50) von dem Energieversorgungsnetz (20) getrennt ist.

13. Verfahren zum Betrieb einer Netzersatzanlage zum wahlweisen Betreiben einer Verbraucheranordnung (50) an einem Energieversorgungsnetz (20) oder an einer lokalen Energieerzeugungseinrichtung (60) unter Trennung vom Energieversorgungsnetz (20), wobei die Netzersatzanlage, nach einem der Ansprüche 10 bis 12 ausgelegt ist, mit den Schritten:
- Verbinden des Neutralleiters (N) der Verbraucheranordnung (50) mit dem Erdungsleiter (PE) über den mindestens einen Schließkontakt (11.1) der Schalteinrichtung (11), wenn die Verbraucheranordnung mit der lokalen Energieerzeugungseinrichtung (60) betrieben werden soll,
- Bereitstellen eines Strompfades, der ausgehend von einem mit Spannung beaufschlagten Leiter (L1) über den Erdungsleiter (PE) zu dem Neutralleiter (N) führt, durch Verbinden des gegenüber dem Neutralleiter (N) mit Spannung beaufschlagten Leiters (L1) mit dem Erdungsleiter (PE) über ein stromreduzierendes Element,
- Detektion eines in dem Strompfad fließenden Stroms über einen Stromsensor (13), der innerhalb des Strompfades in einer Reihenschaltung zu dem mindestens einen Schließkontakt (11.1) und/oder zu dem stromreduzierenden Element angeordnet ist,
- Vergleich des über den Stromsensor (13) fließenden Stroms mit einem vorgegebenen Stromschwellenwert, und
- Signalisieren einer nicht vorhandenen und/oder nicht korrekt vorhandenen Verbindung des Neutralleiters (N) der Verbraucheranordnung (50) mit dem Erdungsleiter (PE), wenn über den Stromsensor kein Strom fließt oder der über den Stromsensor (13) fließende Strom kleiner als der vorgegebene Stromschwellenwert ist.

14. Verfahren nach Anspruch 13, wobei das Signalisieren einer nicht vorhandenen und/oder nicht korrekt vorhandenen Verbindung des Neutralleiters (N) der Verbraucheranordnung (50) mit dem Erdungsleiter (PE) eine Unterdrückung des Energieflusses von der lokalen Energieerzeugungseinrichtung (60) zu der Verbraucheranordnung (50) bewirkt.

15. Verfahren nach Anspruch 14, wobei die Unterdrückung des Energieflusses von der lokalen Energieerzeugungseinrichtung (60) zu der Verbraucheranordnung (50) dadurch erfolgt, dass die lokale Energieerzeugungseinrichtung (60) von der Verbraucheranordnung (50) galvanisch getrennt wird.

## Claims

1. A grounding device (10) for an emergency power system to connect a neutral conductor (N) of a load arrangement (50) to a grounding conductor (PE) via at least one normally open contact (11.1) of a switching device (11), **characterized in that**
- an energized conductor (L1), to which a voltage is applied relative to the neutral conductor (N), is switchably connected to the grounding conductor (PE) via a series connection of a current-reducing element and a further normally open contact (11.3)
- wherein, as a result of the connection of the grounding conductor (PE) to the energized conductor (L1) via the current-reducing element, a current path is created which, starting at the energized conductor (L1), leads to the neutral conductor (N) via the grounding conductor (PE),
- wherein a current then flows in the current path when the grounding conductor (PE) is connected to the neutral conductor (N) via the at least one normally open contact (11.1), and
- wherein a current sensor (13) is arranged within the current path in series connection with the at least one normally open contact (11.1) and/or with the current-reducing element.

2. The grounding device (10) as claimed in claim 1, wherein the at least one normally open contact (11.1) and the further normally open contact (11.3) are commonly-actuated contacts of the switching device (11).

3. The grounding device (10) as claimed in one of claims 1 to 2, wherein, for reason of redundancy, a second normally open contact (11.2) is connected in parallel with the at least one normally open contact (11.1) and wherein, optionally, the second normally open contact (11.2) and the at least one normally open contact (11.1) are commonly-actuated contacts of the switching device (11).

4. The grounding device (10) as claimed in one of claims 1 to 3, wherein the current-reducing element is a capacitor (16).

5. The grounding device (10) as claimed in claim 4, wherein an auxiliary contact (11.5) of the switching device (11) is connected in parallel with the capacitor (16).

6. The grounding device (10) as claimed in one of claims 1 to 5, wherein a fuse (17) is arranged in a series connection with the at least one normally open contact (11.1) and/or with the current-reducing element.

7. The grounding device (10) as claimed in claim 6, wherein the fuse (17) is arranged between the conductor (L1) and the grounding conductor (PE).

8. The grounding device (10) as claimed in one of claims 1 to 7, comprising a monitoring circuit (15) which is configured, by means of the current sensor (13), to monitor a current flow via the at least one normally open contact (11.1) of the switching device (11).

9. The grounding device (10) as claimed in claim 8, wherein the monitoring circuit (15) is further configured to monitor an auxiliary contact (11.4) of the switching device (11).

10. An emergency power system for the optional operation of a load arrangement (50) on a power supply grid (20), or on a local power generating facility (60), by the disconnection thereof from the power supply grid (20), **characterized in that** the emergency power system comprises a grounding device (10) as claimed in one of claims 1 to 9.

11. The emergency power system as claimed in claim 10, which is confgured to disconnect the load arrangement (50) from the local power generating facility (60) if no current flows via the at least one normally open contact (11.1) of the switching device (11), or if a current flows, which is smaller than a predefined current threshold value.

12. The emergency power system as claimed in claim 10 or 11, wherein the grounding device (10) is configured to connect the neutral conductor (N) of the load arrangement (50) with the grounding conductor (PE), if the load arrangement (50) is disconnected from the power supply grid (20).

13. A method for operating an emergency power system for the optional operation of a load arrangement (50) on a power supply grid (20), or on a local power generating facility (60), by the disconnection thereof from the power supply grid (20), wherein the emergency power system is designed as claimed in one of claims 10 to 12, comprising the following steps:
- Connection of the neutral conductor (N) of the load arrangement (50) with the grounding conductor (PE) via the at least one normally open contact (11.1) of the switching device (11), if the load arrangement is to be operated using the local power generating facility (60),
- Provision of a current path, which, starting at an energized conductor (L1), to which a voltage is applied, leads to the neutral conductor (N) via the grounding conductor (PE), by the connection of the energized conductor (L1), to which the voltage is applied relative to the neutral conductor (N), with the grounding conductor (PE) via a current-reducing element,
- Detection of a current flowing in the current path by means of a current sensor (13), which is arranged within the current path in a series connection with the at least one normally open contact (11.1) and/or with the current-reducing element,
- Comparison of the current flowing in the current sensor (13) with a predefined current threshold value, and
- Signaling of an absent and/or of an incorrectly established connection between the neutral conductor (N) of the load arrangement (50) and the grounding conductor (PE), if no current is flowing in the current sensor (13), or the current flowing in the current sensor (13) is smaller than the predefined current threshold value.

14. The method as claimed in claim 13, wherein the signaling of an absent and/or of an incorrectly established connection of the neutral conductor (N) of the load arrangement (50) with the grounding conductor (PE) results in the suppression of the energy flow from the local power generating facility (60) to the load arrangement (50).

15. The method as claimed in claim 14, wherein the suppression of the energy flow from the local power generating facility (60) to the load arrangement (50) is provided such, that the local power generating facility (60) is galvanically isolated from the load arrangement (50).

## Revendications

1. Dispositif de mise à la terre (10) pour un groupe électrogène de secours pour relier un conducteur neutre (N) d'un groupe de consommateurs (50) à un conducteur de protection (PE) par l'intermédiaire d'au moins un contact de fermeture (11.1) d'un dispositif de commutation (11), **caractérisé en ce que**
- un conducteur sous tension (L1) par rapport au conducteur neutre (N) est relié au conducteur de protection (PE) par un circuit en série comprenant un élément réducteur de courant et un autre contact de fermeture (11.3),
- dans lequel un chemin du courant est formé en reliant le conducteur de protection (PE) au conducteur sous tension (L1) via l'élément réducteur de courant, lequel chemin de courant mène du conducteur sous tension (L1) via le conducteur de protection (PE) au conducteur neutre (N),
- dans lequel un courant circule dans le chemin du courant lorsque le conducteur de protection (PE) est relié au conducteur neutre (N) par l'intermédiaire d'au moins un contact de fermeture (11.1), et
- dans lequel un capteur de courant (13) est disposé dans le chemin du courant dans un montage en série avec le au moins un contact de fermeture (11.1) et/ou avec l'élément réducteur de courant.

2. Dispositif de mise à la terre (10) selon la revendication 1, dans lequel le au moins un contact de fermeture (11.1) et l'autre contact de fermeture (11.3) sont des contacts actionnés conjointement du dispositif de commutation (11).

3. Dispositif de mise à la terre (10) selon l'une des revendications 1 à 2, dans lequel un deuxième contact de fermeture (11.2) est monté en parallèle avec le au moins un contact de fermeture (11.1) pour des raisons de redondance, et dans lequel, le cas échéant, le deuxième contact de fermeture (11.2) et le au moins un contact de fermeture (11.1) sont des contacts actionnés conjointement du dispositif de commutation (11).

4. Dispositif de mise à la terre (10) selon l'une des revendications 1 à 3, dans lequel l'élément réducteur de courant est un condensateur (16).

5. Dispositif de mise à la terre (10) selon la revendication 4, dans lequel un contact auxiliaire (11.5) du dispositif de commutation (11) est connecté en parallèle avec le condensateur (16).

6. Dispositif de mise à la terre (10) selon l'une des revendications 1 à 5, dans lequel un fusible (17) est disposé dans un montage en série avec le au moins un contact de fermeture (11.1) et/ou avec l'élément réducteur de courant.

7. Dispositif de mise à la terre (10) selon la revendication 6, dans lequel le fusible (17) est disposé entre le conducteur sous tension (L1) et le conducteur de protection (PE).

8. Dispositif de mise à la terre (10) selon l'une des revendications 1 à 7, comprenant un circuit de surveillance (15) qui est configuré pour surveiller un flux de courant via le au moins un contact de fermeture (11.1) du dispositif de commutation (11) à l'aide du capteur de courant (13).

9. Dispositif de mise à la terre (10) selon la revendication 8, dans lequel le circuit de surveillance (15) est en outre adapté pour surveiller un contact auxiliaire (11.4) du dispositif de commutation (11).

10. Groupe électrogène de secours pour faire fonctionner au choix un groupe de consommateurs (50) sur un réseau d'alimentation électrique (20) ou sur un dispositif local de production d'énergie (60) tout en étant déconnecté du réseau d'alimentation électrique (20), **caractérisé en ce que** le groupe électrogène de secours comporte un dispositif de mise à la terre (10) selon l'une des revendications 1 à 9.

11. Groupe électrogène de secours selon la revendication 10, qui est conçu pour déconnecter le groupe de consommateurs (50) du dispositif local de production d'énergie (60) si aucun courant ne circule par le au moins un contact de fermeture (11.1) du dispositif de commutation (11) ou si un courant circule qui est inférieur à une valeur seuil de courant prédéterminée.

12. Groupe électrogène de secours selon la revendication 10 ou 11, dans lequel le dispositif de mise à la terre (10) est agencé pour connecter le conducteur neutre (N) du groupe de consommateurs (50) au conducteur de protection (PE) lorsque le groupe de consommateurs (50) est déconnecté du réseau d'alimentation électrique (20).

13. Procédé d'exploitation d'un groupe électrogène de secours pour l'exploitation sélective d'un groupe de consommateurs (50) sur un réseau d'alimentation électrique (20) ou sur un dispositif local de production d'énergie (60) en étant déconnecté du réseau d'alimentation électrique (20), le groupe électrogène de secours étant conçu selon l'une des revendications 10 à 12, comportant les étapes suivantes :
- le raccordement du conducteur neutre (N) du groupe de consommateurs (50) au conducteur de protection (PE) par l'intermédiaire d'au moins un contact de fermeture (11.1) du dispositif de commutation (11), si le groupe de consommateurs doit fonctionner avec le dispositif local de production d'énergie (60),
- Mise à disposition d'un chemin du courant qui, partant d'un conducteur sous tension (L1), mène via le conducteur de protection (PE) au conducteur neutre (N) en reliant le conducteur sous tension (L1) par rapport au conducteur neutre (N) au conducteur de protection (PE) via un élément réducteur de courant,
- Détection d'un courant circulant dans le chemin du courant par un capteur de courant (13) qui est disposé dans le chemin du courant dans un montage en série avec au moins un contact de fermeture (11.1) et/ou avec l'élément réducteur de courant,
- la comparaison du courant traversant le capteur de courant (13) avec une valeur seuil de courant prédéterminée, et
- Signalisation d'une connexion inexistante et/ou incorrecte du conducteur neutre (N) du groupe de consommateurs (50) au conducteur de protection (PE) si aucun courant ne passe par le capteur de courant ou si le courant passant par le capteur de courant (13) est inférieur à la valeur seuil de courant prédéterminée.

14. Procédé selon la revendication 13, dans lequel la signalisation d'une connexion inexistante et/ou incorrecte du conducteur neutre (N) du groupe de consommateurs (50) au conducteur de protection (PE) provoque une sous-suppression du flux d'énergie du dispositif local de production d'énergie (60) vers le groupe de consommateurs (50).

15. Procédé selon la revendication 14, dans lequel la suppression du flux d'énergie du dispositif local de production d'énergie locale (60) vers le groupe de consommateurs (50) est effectuée en séparant galvaniquement le dispositif local de production d'énergie (60) du groupe de consommateurs (50).
